## Europäisches Patentamt
## European Patent Office
## Office européen des brevets

(11) Numéro de publication: **0 143 698**
**B1**

(12) **FASCICULE DE BREVET EUROPÉEN**

(45) Date de publication du fascicule du brevet:
**20.05.87**

(21) Numéro de dépôt: **84402341.6**

(22) Date de dépôt: **16.11.84**

(51) Int. Cl.⁴: **C 23 C 14/50, B 25 B 5/14**

(54) Support adaptable à des pièces de formes et dimensions variées.

(30) Priorité: **25.11.83 FR 8318824**

(43) Date de publication de la demande:
**05.06.85 Bulletin 85/23**

(45) Mention de la délivrance du brevet:
**20.05.87 Bulletin 87/21**

(84) Etats contractants désignés:
**DE GB NL**

(56) Documents cité:
**DE-A-2 329 906**
**FR-A-2 480 454**
**GB-A-1 048 935**

(73) Titulaire: **Dubois, René, 26, Avenue du Général
Leclerc, F-95380 Louvres (FR)**

(72) Inventeur: **Dubois, René, 26, Avenue du Général
Leclerc, F-95380 Louvres (FR)**

(74) Mandataire: **Mongrédien, André, c/o BREVATOME
25, rue de Ponthieu, F-75008 Paris (FR)**

LIBER, STOCKHOLM 1987

EP 0 143 698 B1

## Description

La présente invention est relative au problème que pose le maintien de pièces sur lesquelles on a à effectuer un traitement tel qu'un dépôt par évaporation sous vide, ou par pulvérisation cathodique.

Généralement, pour un tel traitement industriel de séries de pièces de mêmes formes et dimensions on prévoit des supports de formes déterminées pour recevoir ces pièces grâce à des ouvertures ou des épaulements appropriés.

Par contre, de tels supports utilisables industriellement ne peuvent s'adapter aux besoins des laboratoires de par la diversité des formes et dimensions des pièces à y traiter et leur petit nombre.

L'invention a précisément pour but d'apporter une solution à ce dernier problème.

A cet effet, l'invention a pour objet un support adaptable à des pièces de formes et dimensions variées comportant un cadre plan à plusieurs côtés, chaque côté présentant une série de glissières perpendiculaires au côté et autant de barrettes planes longitudinales qu'il y a de glissières, placées chacune dans une glissière pour y coulisser, et étant munie de moyens de fixation en une position variable choisie de la barrette dans la glissière. Chaque barrette présente sur toute sa périphérie un épaulement étroit de support des pièces. De préférence le cadre est fermé.

Ainsi, avec un tel support, en fonction d'un ensemble disparate de pièces à traiter, on déplacera en conséquence et immobilisera en position un certain nombre de barrettes pour réaliser à l'intérieur du cadre un ensemble adapté d'épaulements étroits de support apte à supporter cet ensemble disparate de pièces par leurs bords périphériques.

L'invention sera mieux comprise à l'aide de la description suivante d'un mode particulier de réalisation donné uniquement à titre d'exemple, non limitatif.

On se reportera au dessin annexé, sur lequel :
- la figure 1 est une vue en perspective d'un support selon l'invention, et
- la figure 2 représente, en plan, une disposition particulière de barrettes de support portant un ensemble disparate de pièces variées à traiter.

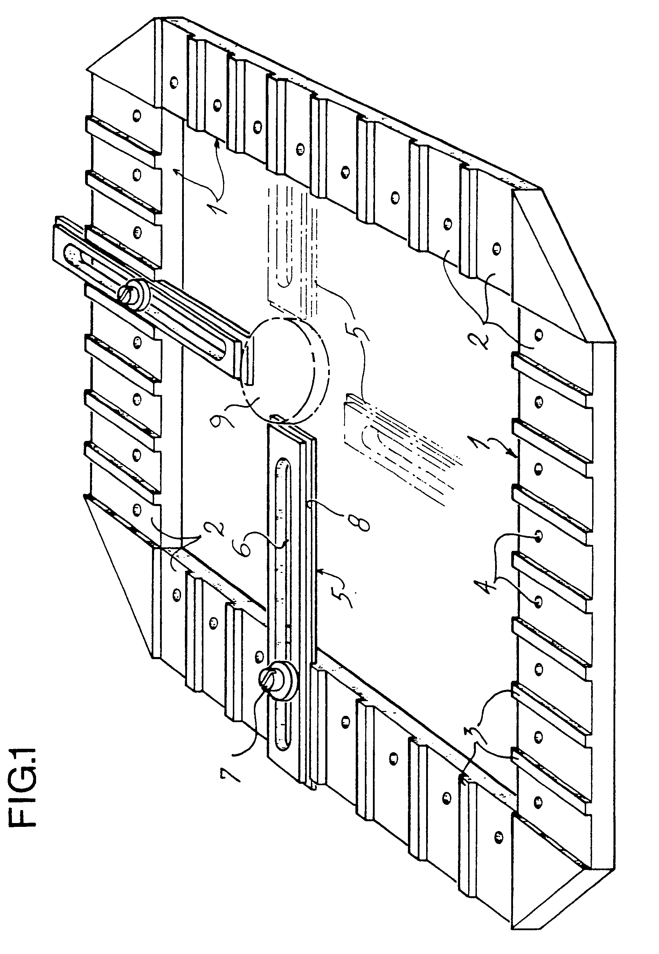

Le support représenté sur la figure 1 a une forme de cadre carré plan comportant quatre côtés orthogonaux 1.

Chaque côté présente huit glissières 2, perpendiculaires au côté et séparées les unes des autres par des bossages longitudinaux 3. Le fond de chaque glissière présente un trou fileté 4.

Chaque glissière 2 des côtés 1 du cadre plan est destinée à recevoir une barrette 5 dont une seule est représentée sur la figure 1.

Chaque barrette a une largeur 1 correspondant, avec un faible jeu, à la largeur de la glissière dans laquelle elle est montée pour pouvoir coulisser. La longueur L de chaque barrette est supérieure à la largeur du côté 1 et telle que, lorsqu'elle est coulissée à fond vers l'intérieur du cadre, son extrémité soit voisine du côté opposé à celui dans lequel elle coulisse.

Chaque barrette présente axialement et longitudinalement une fente 6 sur presque toute sa longueur. Une vis 7 à tige filetée, vissée dans les trous 4, permet de fixer en toute position relative choisie une barrette 5 par rapport à sa glissière 2.

Enfin, chaque barrette présente sur toute sa périphérie un épaulement étroit 8 de support des pièces à traiter.

On a représenté en traits mixte une pièce 9 supportée par quatre barrettes 5, dont deux ont été schématisées en traits mixtes.

Lorsque le traitement à effectuer est, par exemple, une évaporation sous vide, on comprend que le cadre est introduit et supporté de manière appropriée à l'intérieur d'une enceinte sous vide, que le creuset chauffé contenant la substance à évaporer est alors placé sous le cadre supportant les pièces dont les surfaces à traiter sont donc orientées vers le bas puisque la substance à évaporer s'évapore vers le haut.

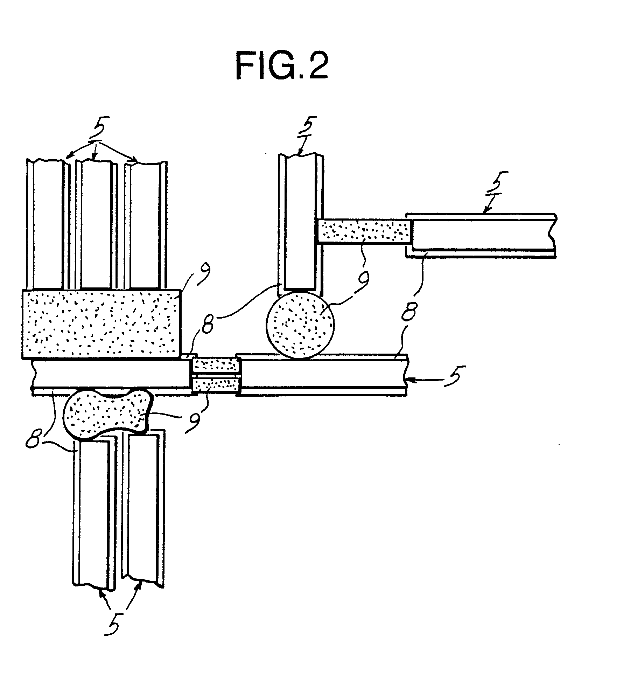

On a représenté sur la figure 2, en plan, une configuration particulière d'un ensemble de certaines des barrettes 5, déplacées et immobilisées dans leurs glissières, pour venir occuper la surface normalement libre de l'intérieur du cadre carré, afin de supporter selon cet exemple, un ensemble particulier correspondant disparate de pièces à traiter variées, référencées 9. On voit que ces diverses pièces 9 reposent par leurs périphéries sur les épaulements étroits de support 8 des différentes barrettes 5.

Bien que l'on ait décrit un moyen très simple de déplacement et immobilisation des barrettes 5 dans leurs glissières 2, tout autre système peut être utilisé tel qu'utilisant des ressorts de friction ou un dispositif de déplacement à entraînement par tiges filetées.

Egalement, un déplacement à commande électronique avec affichage digital, ou tout autre déplacement à commande électro-mécanique peuvent s'appliquer.

## Revendications

1. Support adaptable à des pièces de formes et dimensions variées comportant un cadre plan à plusieurs côtés (1), chaque côté présentant une série de glissières (2) perpendiculaires au côté et, d'autre part, autant de barrettes planes longitudinales (5) qu'il y a de glissières, placées chacune dans une glissière pour y coulisser, et étant munies de moyens de fixation (4, 7) en une position variable choisie de la barrette dans la glissière, caractérisé en ce que chaque barrette présente sur toute sa périphérie un épaulement étroit (8) de support des pièces.

2. Support selon la revendication 1, caractérisé en ce que le cadre (1) est fermé.

**Patentansprüche**

1. Halterung, die an Werkstücke unterschiedlicher Formen und Abmessungen anpaßbar ist, mit einem ebenen Rahmen, der mehrere Seiten (1) aufweist, wobei jede Seite eine Anzahl von senkrecht zur Seite angeordneten Gleitschienen (2) aufweist, sowie ebensoviel ebene, langgestreckte Klemmstege (5) als Gleitschienen vorhanden sind, deren jeder verschiebbar in einer Gleitschiene angeordnet ist und mit einer Befestigungsanordnung (4, 7) versehen ist, um den Klemmsteg in einer vorgegebenen, veränderbaren Stellung in der Gleitschiene festzulegen, dadurch gekennzeichnet, daß jeder Klemmsteg entlang seines gesamten Umfangs einen schmalen Vorsprung (8) zur Werkstückhalterung aufweist.

2. Halterung nach Anspruch 1, dadurch gekennzeichnet, daß der Rahmen (1) geschlossen ist.

**Claims**

1. Support which can be adapted to parts of varied shapes and dimensions and which has a plane frame with several sides (1), each side having a series of slideways (2) perpendicular to the side and, on the other hand, as many plane longitudinal bars (5) as there are slideways, each placed in a slideway so as to slide in it and being equipped with means (4, 7) of fastening the bar in a selected variable position in the slideway, characterized in that each bar has, over its entire periphery, a narrow shoulder (8) for supporting the parts.

2. Support according to Claim 1, characterized in that the frame (1) is closed.

# FIG.1

# FIG.2